# EUROPEAN PATENT SPECIFICATION

(11) **EP 3 255 335 B1**
(45) Date of publication and mention of the grant of the patent: **13.09.2023**
(21) Application number: 16746169.8
(22) Date of filing: 05.02.2016
(51) Int. Cl.: F21S 9/03, F21S 8/08, H01L 31/02, H01L 31/048, H02S 20/10, F21Y 115/10, F21W 131/103

(54) **PHOTOVOLTAIC MODULE**
FOTOVOLTAISCHES MODUL
MODULE PHOTOVOLTAÏQUE

(30) Priority: 05.02.2015 ES 201530144
(43) Date of publication of application: 13.12.2017
(73) Proprietor: Caviasca, Alessandro, 17130 L'Escala (ES); Studio Itinerante Arquitectura, S.L., 08029 Barcelona (ES)
(72) Inventor: CAVIASCA, Alessandro, 17130 L'Escala (ES)
(74) Representative: Clarke, Modet y Cía., S.L.
(86) International application number: PCT/ES2016/070070
(87) International publication number: WO 2016/124809

(56) References cited:
- EP-A1- 1 500 870
- WO-A1-2013/157696
- CN-A- 102 853 362
- DE-A1- 10 336 543
- DE-A1- 10 336 543
- DE-A1-102010 000 893
- JP-A- H11 163 382
- JP-A- 2010 257 621
- JP-A- 2010 257 621
- KR-A- 20120 018 850
- KR-A- 20130 015 079
- KR-A- 20140 059 658
- US-A1- 2009 038 241
- US-A1- 2009 190 367
- US-A1- 2012 075 855

## Description

### OBJECT OF THE INVENTION

The present invention relates to street furniture comprising a photovoltaic module, of the type comprising a plurality of photovoltaic cells arranged at least partially to define a convex photovoltaic surface.

It consists of a photovoltaic module configured to collect solar energy and the supply of said energy to a receiving device, such as a lighting element, an element of presence, traffic, pollution or Wi-Fi sensors, an intermittent-type traffic signaling element, SOS at service areas, a charging station for mobile telephones or other mobile devices, such as tablets or computers.

Said photovoltaic module may, for example, be incorporated in the upper part of a pole or post for the anchoring or fastening thereof to a fixed point, such as the ground.

### FIELD OF APPLICATION

The field of application of the present invention falls within the sector of the street furniture industry, focusing specifically on the field of public luminaires.

### BACKGROUND OF THE INVENTION

There are many different types of flat photovoltaic panels in the market, and therefore can be considered as the state of the art, which implement several technologies such that a wide variety of devices are currently available.

Generally, there are three main categories of current photovoltaic modules that implement different technologies:
- Crystalline Silicon Modules (made up mainly of crystalline silicon wafers). They may, in turn, be made of Monocrystalline Silicon, wherein the starting material is a single silicon crystal, or Polycrystalline Silicon, formed by multiple grains, each with a different crystallographic orientation.
- Thin-film modules, which are made by expanding or directly depositing the semiconductor on a rigid or flexible substrate that will form part of the photovoltaic module. Semiconductors with a high absorption coefficient are used, such that a few microns of material are sufficient. They are divided into several different types, according to the semiconductor material used in the process of deposition on the substrate. Thin-film technologies are mainly based on: cadmium telluride (CdTe), hydrogenated amorphous silicon (a-Si:H), or copper-indium-gallium diselenide (CIGS).
- Proprietary variants (heterojunction and microspherical silicon).

Also known are photovoltaic modules which have a curved surface, made by joining flat photovoltaic cells, as well as elements that integrate the photovoltaic modules into their own structure such as panels for covering facades and roofs of buildings, tiles or windows.

Moreover, other types of photovoltaic panels with different colors and shapes are known, which are used for better integration of this technology in urban spaces.

Said systems for capturing solar energy often have significant problems of efficiency loss and/or prohibitively high prices; both causes are behind the poor implementation of the latest technologies mentioned above and therefore explain the insignificant presence in the market of said curved photovoltaic modules.

Photovoltaic technology is currently used for producing electric energy to supply different types of urban electronic devices (such as street lamps, electrical vehicle charging stations, or mobile device charging stations), especially in contexts known as "Smart Cities".

Street lamps equipped with an energy collecting system by means of photovoltaic cells, which can store the energy collected by solar radiation are known, wherein battery charging is regulated, luminaires are turned on either from the street lamps themselves or from a distance, and crystalline silicon, amorphous silicon or CIGS/CIS thin-film photovoltaic technology is used, which incorporates presence sensors, uses lithium batteries and also incorporates a system of LED lamps with the possibility of tapping into the electrical grid when the supply of stored electric energy is depleted.

These lighting systems with photovoltaic technology can be grouped into the following main categories:
a. Street lamps with a design made up of several elements and a flat photovoltaic module.
b. Compact street lamps with a flat photovoltaic module.
c. Compact street lamps wherein the photovoltaic module adheres to the luminaire.
d. Compact street lamps wherein the photovoltaic module is situated on the pole.

The previous street lamp groups have the following drawbacks:
a. These are mostly non-compact, non-functional systems, in which generally little attention is paid to design.
b. They also have the drawback of requiring the photovoltaic module to be properly oriented, which may become a limitation for several applications.
c. It is a poorly efficient and not fully integrated system, with a reduced catchment area.
d. The design is limited to a cylindrical shape.

On the other hand, a type of self-sufficient street lamp, designed by the same holder, is known in European patent application EP2522900A1, the object of which is a "photovoltaic solar light with energy self-sufficiency", the purpose of which is to provide a simultaneous solution to the previous problems and drawbacks by means of a compact, integrated and efficient design.

The document EP1500870A1 discloses a solar operated lamp with a plurality of solar cells inserted in a spherical holder that form a solar cell panel.

The document KR20140059658A discloses a street lamp provided with a parasol for protecting from the sunlight. Other prior art solar operated lighting devices are known from DE10336543 A1, CN102853362 A, JP 2010 257621 A and KR20120018850.

However, no document known to date presents a photovoltaic module with a configuration such that it can collect, manage and supply a receiving device (such as LED-type lighting element) with optimal energy efficiency and with great versatility in its possible use in different types of receiving systems other than a luminaire.

The purpose of the present invention is to create a structural and functional design of a domed photovoltaic module, which, in one of its applications, allows housing in its interior all of the tools for a correct operation thereof, and which is able to be used to supply the collected energy, with optimum energy efficiency, to one or more receiver element(s), such as: a LED-type luminaire element, a sensor element of any type, such as presence, traffic, pollution, Wi-Fi or the like, an intermittent-type traffic signaling element, SOS in service areas, etc., a charging station for mobile phones or other mobile devices, such as tablets or computers, or other elements of all types used on public roads. Furthermore, this photovoltaic module can be used in the nautical sector.

Another object of the present invention is that said photovoltaic module be capable of working independently, be capable of working connected to the electrical grid and to be capable of working in combined mode (independently or on the grid), as appropriate in each case.

### DESCRIPTION OF THE INVENTION

The object of the invention is achieved by street furniture having the features of claim 1. Preferred embodiments of the invention are subject of the depending claims.

The photovoltaic module externally comprises a photovoltaic surface of a convex, domed configuration, said configuration providing several features and advantages with respect to other types of configurations currently existing on the market.

In one possible application thereof, said photovoltaic module may comprise an electrical connection element connected to said photovoltaic surface, the purpose of which is to electrically and safely connect said photovoltaic module to other receiving devices, so that said photovoltaic module supplies the energy collected to one or several receiving device(s).

The photovoltaic surface consists of a multitude of photovoltaic cells connected together, achieving this particular and advantageous convex, domed configuration through the use of a specific type of photovoltaic cells proven to provide suitable flexibility to said surface in order to enable it to bend and be able to acquire said specific configuration, while fulfilling all of the benefits in terms of capacity and efficiency in collecting solar energy.

The materials for manufacturing the photovoltaic cells making up the photovoltaic module, which have been selected as being most suitable for carrying out this invention, after numerous trials and field tests conducted by the applicant, are:
(a)non-flexible (rigid technology) Crystalline Silicon technology (Si-x), or
(b) flexible, thin-film technologies, which mainly encompass those based on cadmium telluride (CdTe), on hydrogenated amorphous silicon (a-Si:H), or on copper-indium-gallium diselenide (CIGS).

Preferably, in thin-film flexible technology, the material that has provided the most satisfying results is copper-indium-gallium diselenide (CIGS), although other types of flexible technology materials have also demonstrated noteworthy results.

On the other hand, the applicant has demonstrated that by partitioning the photovoltaic surface into a plurality of axial portions or segments of the same size, laterally joined to one another and formed, in turn, by multiple photovoltaic cells, provides a number of advantages. The aforementioned plurality of axial portions or segments, laterally joined to one another once mounted, are electrically connected (in series and/or in parallel), each portion/segment to the next.

Advantageously, the applicant has shown and proven that partitioning or subdividing the photovoltaic surface into different axial portions greatly facilitates a correct and easier manufacturing of the module with the indicated curvature.

Preferably, the photovoltaic surface comprises an inner surface made up of a plurality of photovoltaic cells connected together, which is totally or partially covered by an encapsulating outer surface manufactured with a protective material, for example a fiber-reinforced polymer, crystal or another material equivalent to the two aforementioned materials. Said encapsulation has the function of protecting the inner photovoltaic surface from deterioration caused by external elements, such as rain, snow, dust or wind.

Optionally, the photovoltaic surface may comprise a thermally insulated inner surface or sheet which is arranged on the inner part of the entire photovoltaic surface, or a part thereof, for example, made with a "carpet"-type material. The main purpose of said sheet or insulated surface is none other than minimizing the heat in the space remaining inside the photovoltaic module due to the action of the photovoltaic cells themselves, and thereby preventing wear or even a failure of the elements which are located inside the photovoltaic module (for example, a photovoltaic energy storage element) due to the high temperatures that are reached in this inner space.

The photovoltaic surface with a domed configuration is truncated at the top, defining an upper opening. Arranged in said upper opening is an element in the form of a vault, which closes the inner volume of the photovoltaic module at the top.

Said vault-shaped element is preferably configured in such a way that a user may easily remove it, in order to, for example, be able to easily access the inside of the module for maintenance tasks of the storage and control devices. This vault-shaped element is preferably not made of photovoltaic cells.

In a preferred embodiment of the invention, a lower element is arranged at the lower opening of the photovoltaic surface, which closes the inner volume of the photovoltaic module at the bottom. This lower element is preferably not made of photovoltaic cells, but of another material.

The particular and advantageous shape of the photovoltaic module, the arrangement of the photovoltaic cells in the same, as well as the overall shape of the panel, were designed after numerous theoretical and field studies were carried out by the holder, who has investigated how to use the maximum amount of electric energy potentially produced by the panel, as well as aspects which relate to the electrical connections of the portions of the photovoltaic cells, and, lastly, also aesthetic aspects.

It has been found that said upper truncated domed geometry of the photovoltaic module, presents optimal conditions if it has the following parameters:
- Lower diameter (D2) / Height (H) = comprised between values 1.3 and 1.6.
- Upper diameter (D1) / Height (H) = comprised between values 0.5 and 0.9.
- Lower angle of curvature of the generatrix (Alpha 1) = comprised between values 80° and 95°.
- Middle angle of curvature of the generatrix (Alpha 2) = comprised between values 65° and 75°
- Upper angle of curvature of the generatrix (Alpha 3) = comprised between values 35° and 46°

In one of the possible applications, said photovoltaic module further comprises, at least, photovoltaic energy storage means and/or photovoltaic energy control means. The aforementioned photovoltaic energy storage means and/or the control means are preferably arranged on the inside of said photovoltaic surface in a domed configuration, both means being electrically connected to said photovoltaic module.

The photovoltaic module is also adapted to be connected to one or more collected energy receiving device(s), wherein the energy receiving device(s) is/are preferably selected from one element, or a combination of elements, from the group made up of:
- a lighting element made up of LEDs or OLEDs; and/or
- a sensor element for: presence, traffic, pollution, or Wi-Fi; and/or
- an intermittent-type traffic signaling element, or SOS in service areas; and/or
- a charging station for mobile telephones or other mobile elements such as tablets or computers; and/or
- an electronic element of the type used on public roads.

The mentioned receiving device(s) may form part of the photovoltaic module, or be external to the same and be connected to it by adequate means.

Optionally, the photovoltaic module can have an optimal ventilation system with the aim of guaranteeing correct operation of the tools and elements or devices contained inside the module. Said ventilation system is made up of a plurality of openings for ventilation preferably arranged on the lower part, adapted to create a natural air current that penetrates said lower openings and exits through other openings provided on the upper part, in the contact between the photovoltaic module and the vault.

One possible exemplary embodiment is a photovoltaic module which is configured to supply the collected energy to a receiving device made up of a lighting element, for example, LEDs, the photovoltaic module being integrated in, and forming part of, the lighting element or luminaire.

In this particular embodiment, the lower opening of the photovoltaic surface is closed by a lower element wherein a plurality of light sources, for example, LEDs, are arranged in specific positions, such that the number of light sources, the different optics thereof and the specific positions in which said light sources are placed in the lower element determine different photometries, depending on the area to be illuminated.

Further details and characteristics will become apparent in the course of description which follows, wherein reference is made to the accompanying drawings, which, by way of illustration and not limitation, provide a graphic representation of the invention.

### DESCRIPTION OF THE DRAWINGS

The following is a list of the different parts found in the accompanying figures and identified by the following numbers;
(1) street lamp,
(2) post,
(3) photovoltaic module,
(4) photovoltaic surface,
(5) vault,
(6) lower element,
(7) light source,
(8) upper opening of the photovoltaic surface,
(9) energy storage means, or battery,
(10) control means or control electronics,
(11) support element for the battery and electronics,
(12) luminaire,
(13) portions or segments,

In the figures:
Figure 1 is an elevational view of a luminaire (12) integrated in the upper part of a street lamp (1) anchored to the ground, and the photovoltaic module (3) forming part of said luminaire (12);
Figure 2 is a detailed perspective view of the luminaire (12) of Figure 1, which comprises the photovoltaic module (3), comprising a vault (5) at the top and a lower element (6) below, mounted on the upper end of a post (2);
Figure 3 is a top plan view of the luminaire (12) of Figure 1, wherein the photovoltaic surface (4) and the vault (5) can be seen;
Figure 4 is a bottom plan view of the luminaire (12) of Figure 1, wherein the specific arrangement of the light sources (7) can be seen;
Figure 5 is an elevational transverse cross-section of the luminaire (12) of Figure 1, wherein the battery (9), the control means or control electronics (10) and the support element for the battery and electronics (11) can be seen;
Figure 6 shows schematically a preferred example of the parameters that define the specific geometry of the photovoltaic module (3);
Figure 7 shows a perspective view of a possible example of the outer configuration of the photovoltaic module (3); and
Figure 8 shows another possible example of the outer configuration of the photovoltaic module (3), wherein the photovoltaic surface (4) is partitioned into portions or segments (13).

### PREFERRED EMBODIMENT

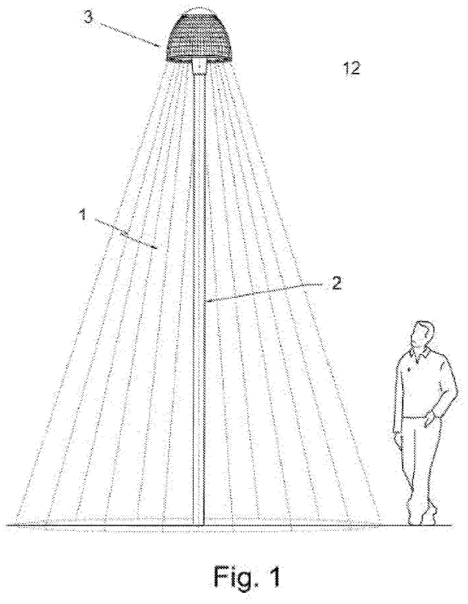

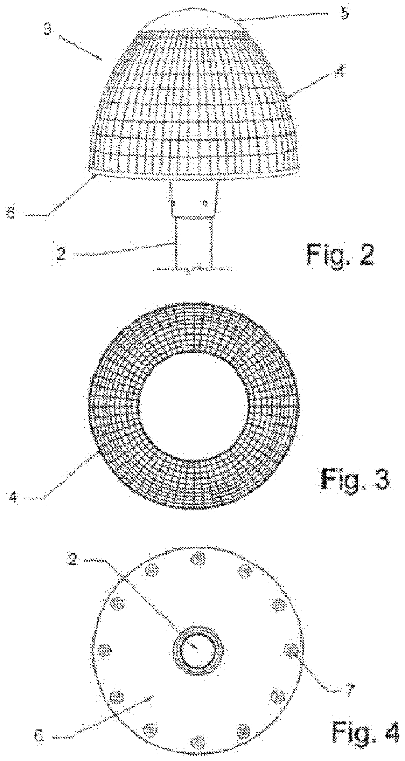

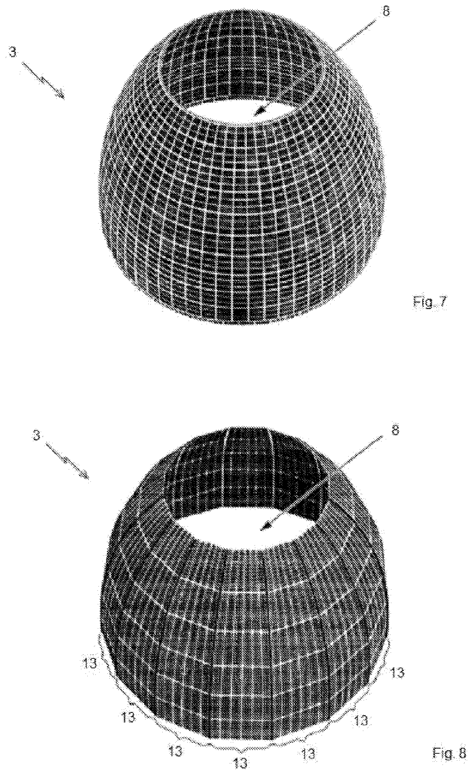

In one of the preferred embodiments, and as can be seen in Figures 1 to 8, the luminaire (12), incorporated in the upper end of the post (2) forming a street lamp (1), incorporates a photovoltaic module

In the specific case of Figures 1 to 8, the photovoltaic module (3) comprises an outer photovoltaic surface (4) of a convex configuration wherein the different photovoltaic cells are arranged, a vault (5) being arranged in the upper part of said photovoltaic surface (4), and a lower element (6) on the lower part. In said lower element (6) a plurality of light sources (7), for example LEDs, are arranged in specific positions, such that the number of light sources (7), the different optics thereof and the specific positions in which said light sources are placed (7) in the lower element determine different photometries, depending on the area to be illuminated.

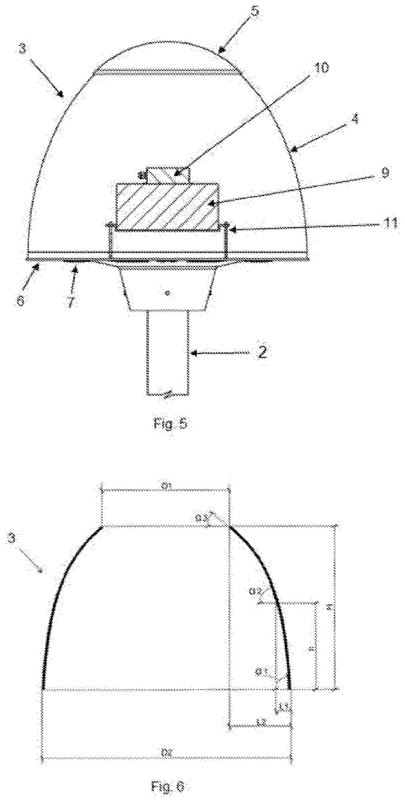

The internal structure of the luminaire (12) can be seen in Figure 5. Arranged in the inner volume of the photovoltaic module (3) all electric and electronic means are provided for the perfect operation thereof, and which convert the energy collected by the photovoltaic cells on the photovoltaic surface (4) into electric energy for lighting up light sources (7).
At least one photovoltaic energy storage means, or a battery (9) and control means (10) are provided, which are preferably arranged on a support element (11), preferably arranged at a certain height with respect to the lower element, in order facilitate access by the user in the maintenance tasks when disassembling the vault (5) from the top.

A specific preferred geometry of the photovoltaic surface (3), shown in Figure 10, has the following parameters:
- Lower diameter (D2) = 800mm.
- Upper diameter (D1) = 385mm.
- Height (H) = 537mm.
- Height (h) of change of curvature = 268 mm.
- Lower angle of curvature of the generatrix (Alpha 1)= 87.5°
- Angle of change of curvature of the generatrix (Alpha 2) = 71.2°
- Upper angle of curvature of the generatrix (Alpha 3) = 41.5^{e}
- Changeover distance of curvature = 41.5 mm.
- Starting distance top opening = 204.7 mm.

The present invention having been sufficiently described, in conjunction with the accompanying drawings, it is easy to understand that any detailed modifications that may be designed can be added to the same, provided that the scope of the invention, as defined by the appended claims, is not altered.

## Claims

1. A street furniture comprising: a photovoltaic module (3) of the type comprising a plurality of photovoltaic cells connected together, arranged, at least partially, to define a photovoltaic surface (4) of a convex, domed configuration with respect to the ground, wherein the photovoltaic surface (4) has a lower angle of curvature of its generatrix (Alpha 1) which is greater than the middle angle of curvature of said generatrix (Alpha 2), and the middle angle of curvature of said generatrix (Alpha 2) is greater than the upper angle of curvature of said generatrix (Alpha 3), wherein said photovoltaic surface (4) with a domed configuration is truncated at the top, defining an upper opening (8); and wherein the photovoltaic surface (4) has the following parameters:
- Lower diameter (D2) / Height (H) = comprised between the values 1.3 and 1.6,
- Upper diameter (D1) / Height (H) = comprised between the values 0.5 and 0.9,
- Lower angle of curvature of the generatrix (Alpha 1) = comprised between the values 80° and 95°,
- Middle angle of curvature of the generatrix (Alpha 2) = comprised between the values 65° and 75°,
- Upper angle of curvature of the generatrix (Alpha 3) = comprised between the values 35° and 46°.

2. The street furniture according to any of the preceding claims, **characterized in that** the photovoltaic surface (4) comprises a plurality of axial portions or segments (13), each segment (13) being electrically connected to the next.

3. The street furniture according to any of the preceding claims, **characterized in that** the photovoltaic surface (4) is made of Crystalline Silicon, or of CIGS, or other thin-film technologies.

4. The street furniture according to any of the preceding claims, **characterized in that** the photovoltaic surface (4) is covered by an encapsulating outer surface manufactured with a protective material, such as fiber-reinforced polymers or crystal, to protect against external elements.

5. The street furniture according to any of the preceding claims, **characterized in that** a vault-shaped element (5) is provided, which is arranged at the upper opening (8) of the photovoltaic surface (4) so as to close the inner volume of the photovoltaic module (3) at the top.

6. The street furniture according to any of the preceding claims, **characterized in that** it comprises photovoltaic energy storage means, or a battery (9) and/or control means or control electronics (10), arranged inside said photovoltaic surface (4), both means being electrically connected to said photovoltaic module (3).

7. The street furniture according to any of the preceding claims, **characterized in that** the photovoltaic surface (4) comprises a lower opening and **in that** the lower element (6) which closes of the inner volume of the photovoltaic module (3) at the bottom is arranged in said lower opening of the photovoltaic surface (4).

8. The street furniture according to claim 7, **characterized in that** one or more light sources (7) are arranged in the lower element (6).

9. The street furniture according to any of the preceding claims, **characterized in that** it is adapted to be connected to one or more collected energy receiving device(s), wherein the energy receiving device(s) is/are preferably selected from one element, or a combination of elements, from the group made up of:
- a lighting element made up of LEDs or OLEDs;
- a sensor element for: presence, traffic, pollution, or Wi-Fi;
- an intermittent-type traffic signaling element, or SOS in service areas;
- a charging station for mobile telephones or other mobile elements such as tablets or computers;
- an electronic element of the type used on public roads.

10. The street furniture according to any of the preceding claims, **characterized in that** it comprises a thermally insulated inner sheet or surface arranged on the inner part of the entire photovoltaic surface (4), or a part thereof.

11. The street furniture according to any of the preceding claims, **characterized in that** it comprises a plurality of openings for ventilation preferably arranged on the lower part, adapted to create a natural air current that penetrates said lower openings and exits through other openings provided on the upper part, in the contact between the photovoltaic module (3) and the vault (5).

12. The street furniture according to claim 1, **characterized in that** the photovoltaic surface (4) has the following parameters:
- Lower diameter (D2) = 800mm,
- Upper diameter (D1) = 385mm,
- Height (H) = 537mm,
- Height (h) of change of curvature = 268 mm,
- Lower angle of curvature of the generatrix (Alpha 1) = 87.5°
- Angle of change of curvature of the generatrix (Alpha 2) = 71.2 and Upper angle of curvature of the generatrix (Alpha 3) = 41.5°
- Changeover distance of curvature = 41.5 mm,
- Starting top opening distance = 204.7 mm.

13. The street furniture according to any of the preceding claims, **characterized in that** said street furniture is a luminaire (12).

## Patentansprüche

1. Straßenausstattung umfassend:
ein fotovoltaisches Modul (3) der Art umfassend eine Vielzahl von miteinander verbundenen fotovoltaischen Zellen, welche, mindestens teilweise, angeordnet sind, um eine Fotovoltaikfläche (4) mit einer konvexen, kuppelförmigen Ausbildung in Bezug auf den Boden zu definieren, wobei die Fotovoltaikfläche (4) einen unteren Krümmungswinkel dessen Erzeugende (Alpha 1) aufweist, welcher größer als der mittlere Krümmungswinkel der genannten Erzeugende (Alpha 2) ist, und der mittlere Krümmungswinkel der genannten Erzeugende (Alpha 2) größer als der obere Krümmungswinkel der genannten Erzeugende (Alpha 3) ist, wobei die genannte Fotovoltaikfläche (4) mit einer kuppelförmigen Ausbildung oben abgestumpft ist, unter Definierung einer oberen Öffnung (8); und wobei die Fotovoltaikfläche (4) die folgenden Parameter aufweist:
- Unterer Durchmesser (D2) / Höhe (H) = zwischen den Werten 1,3 und 1,6 enthalten,
- Oberer Durchmesser (D1) / Höhe (H) = zwischen den Werten 0,5 und 0,9 enthalten,
- Unterer Krümmungswinkel der Erzeugende (Alpha 1) = zwischen den Werten 80° und 95° enthalten,
- Mittlerer Krümmungswinkel der Erzeugende (Alpha 2) = zwischen den Werten 65° und 75° enthalten,
- Oberer Krümmungswinkel der Erzeugende (Alpha 3) = zwischen den Werten 35° und 46° enthalten.

2. Straßenausstattung nach einem der vorhergehenden Ansprüche, **dadurch gekennzeichnet, dass** die Fotovoltaikfläche (4) eine Vielzahl von axialen Abschnitten oder Segmenten (13) umfasst, wobei jedes Segment (13) mit dem Nächsten elektrisch verbunden ist.

3. Straßenausstattung nach einem der vorhergehenden Ansprüche, **dadurch gekennzeichnet, dass** die Fotovoltaikfläche (4) aus kristallinem Silizium, oder aus CIGS, oder anderen Dünnfilmtechnologien hergestellt ist.

4. Straßenausstattung nach einem der vorhergehenden Ansprüche, **dadurch gekennzeichnet, dass** die Fotovoltaikfläche (4) mittels einer verkapselnden Außenfläche gefertigt mit einem Schutzmaterial gedeckt ist, wie faserverstärkten Polymeren oder Kristall, um gegen externe Elemente zu schützen.

5. Straßenausstattung nach einem der vorhergehenden Ansprüche, **dadurch gekennzeichnet, dass** ein gewölbeförmiges Element (5) vorgesehen ist, welches bei der oberen Öffnung (8) der Fotovoltaikfläche (4) angeordnet ist, um das Innenvolumen des fotovoltaischen Moduls (3) oben zu schließen.

6. Straßenausstattung nach einem der vorhergehenden Ansprüche, **dadurch gekennzeichnet, dass** sie fotovoltaische Energiespeichermittel, oder eine Batterie (9) und/oder Steuermittel oder Steuerelektronik (10), welche innerhalb der genannten Fotovoltaikfläche (4) angeordnet sind, umfasst, wobei beide Mittel mit dem genannten fotovoltaischen Modul (3) elektrische verbunden sind.

7. Straßenausstattung nach einem der vorhergehenden Ansprüche, **dadurch gekennzeichnet, dass** die Fotovoltaikfläche (4) eine untere Öffnung umfasst und dass das untere Element (6), welches das Innenvolumen des fotovoltaischen Moduls (3) unten schließt, in der genannten unteren Öffnung der Fotovoltaikfläche (4) angeordnet ist.

8. Straßenausstattung nach Anspruch 7, **dadurch gekennzeichnet, dass** eine oder mehrere Lichtquellen (7) im unteren Element (6) angeordnet ist/sind.

9. Straßenausstattung nach einem der vorhergehenden Ansprüche, **dadurch gekennzeichnet, dass** sie dazu angepasst ist, mit einer oder mehreren Empfangsvorrichtungen für gesammelte Energie verbunden zu werden, wobei die Empfangsvorrichtung(en) für Energie vorzugsweise aus einem Element, oder einer Kombination von Elementen ausgewählt wird/werden, aus der Gruppe bestehend aus:
- einem Beleuchtungselement bestehend aus LEDs oder OLEDs;
- einem Sensorelement für: Anwesenheit, Verkehr, Verschmutzung oder WLAN;
- einem intermittierenden Verkehrssignalisierungselement, oder SOS in Raststätten;
- einer Ladestation für Mobiltelefone oder andere Mobilelemente wie Tablets oder Computer;
- einem elektronischen Element der Art, welche in öffentlichen Straßen verwendet wird.

10. Straßenausstattung nach einem der vorhergehenden Ansprüche, **dadurch gekennzeichnet, dass** sie eine thermisch isolierte Innenfolie oder -fläche umfasst, welche auf dem inneren Teil des gesamten Fotovoltaikfläche (4), oder einem Teil derselben, angeordnet ist.

11. Straßenausstattung nach einem der vorhergehenden Ansprüche, **dadurch gekennzeichnet, dass** sie a Vielzahl von Öffnungen zur Lüftung umfasst, welche vorzugsweise auf dem unteren Teil angeordnet sind und dazu angepasst sind, einen natürlichen Luftstrom zu erzeugen, welcher die genannten unteren Öffnungen durchdringt und durch andere Öffnungen austritt, welche auf dem oberen Teil, im Kontakt zwischen dem fotovoltaischen Modul (3) und dem Gewölbe (5), vorgesehen sind.

12. Straßenausstattung nach Anspruch 1, **dadurch gekennzeichnet, dass** die Fotovoltaikfläche (4) die folgenden Parameter aufweist:
- Unterer Durchmesser (D2) = 800 mm,
- Oberer Durchmesser (D1) = 385 mm,
- Höhe (H) = 537 mm,
- Höhe (h) der Krümmungsänderung = 268 mm,
- Unterer Krümmungswinkel der Erzeugende (Alpha 1) = 87,5°
- Winkel der Krümmungsänderung der Erzeugende (Alpha 2) = 71,2 und oberer Krümmungswinkel der Erzeugende (Alpha 3) = 41,5°
- Wechselabstand der Krümmung = 41,5 mm,
- Anfänglicher oberer Öffnungsabstand = 204,7 mm.

13. Straßenausstattung nach einem der vorhergehenden Ansprüche, **dadurch gekennzeichnet, dass** die genannte Straßenausstattung eine Leuchte (12) ist.

## Revendications

1. Mobilier urbain comprenant :
un module photovoltaïque (3) du type comprenant une pluralité de cellules photovoltaïques reliés les unes aux autres, aménagées, au moins partiellement, pour définir une surface photovoltaïque (4) à configuration bombée convexe par rapport au sol, dans lequel la surface photovoltaïque (4) présente un angle de courbure inférieur de sa génératrice (Alpha 1) qui est plus grand que l'angle de courbure central de ladite génératrice (Alpha 2), et l'angle de courbure central de ladite génératrice (Alpha 2) est plus grand que l'angle de courbure supérieur de ladite génératrice (Alpha 3), dans lequel ladite surface photovoltaïque (4) à configuration bombée est tronquée dans la partie supérieure, en définissant une ouverture supérieure (8) ; et dans lequel la surface photovoltaïque (4) présente les paramètres suivants :
- diamètre inférieur (D2) 1 hauteur (H) = compris entre les valeurs de 1,3 et 1,6,
- diamètre supérieur (D1) 1 hauteur (H) = compris entre les valeurs de 0,5 et 0,9,
- angle de courbure inférieur de la génératrice (Alpha 1) = compris entre les valeurs de 80° et 95°,
- angle de courbure central de la génératrice (Alpha 2) = compris entre les valeurs de 65° et 75°,
- angle de courbure supérieur de la génératrice (Alpha 3) = compris entre les valeurs de 35° et 46°.

2. Mobilier urbain selon l'une quelconque des revendications précédentes, **caractérisé en ce que** la surface photovoltaïque (4) comprend une pluralité de portions ou segments axiaux (13), chaque segment (13) étant électriquement relié au suivant.

3. Mobilier urbain selon l'une quelconque des revendications précédentes, **caractérisé en ce que** la surface photovoltaïque (4) est réalisée en silicium cristallin, ou en CIGS, ou d'autres technologies de couche mince.

4. Mobilier urbain selon l'une quelconque des revendications précédentes, **caractérisé en ce que** la surface photovoltaïque (4) est recouverte par une surface extérieure d'encapsulation réalisée en un matériau de protection, tel que des polymères renforcés de fibres ou du cristal, pour protéger contre les éléments extérieurs.

5. Mobilier urbain selon l'une quelconque des revendications précédentes, **caractérisé en ce qu'**un élément sous forme de voûte (5) est prévu, qui est aménagé dans l'ouverture supérieure (8) de la surface photovoltaïque (4) pour fermer le volume intérieur du module photovoltaïque (3) dans la partie supérieure.

6. Mobilier urbain selon l'une quelconque des revendications précédentes, **caractérisé en ce qu'**il comprend des moyens de stockage d'énergie photovoltaïque, ou une batterie (9) et/ou des moyens de commande ou une électronique de commande (10), aménagés à l'intérieur de ladite surface photovoltaïque (4), les deux moyens étant électriquement reliés audit module photovoltaïque (3).

7. Mobilier urbain selon l'une quelconque des revendications précédentes, **caractérisé en ce que** la surface photovoltaïque (4) comprend une ouverture inférieure et **en ce que** l'élément inférieur (6) qui ferme ledit volume intérieur du module photovoltaïque (3) dans la partie inférieure est aménagé dans ladite ouverture inférieure de la surface photovoltaïque (4).

8. Mobilier urbain selon la revendication 7, **caractérisé en ce que** une ou plusieurs sources lumineuses (7) sont aménagées dans l'élément inférieur (6).

9. Mobilier urbain selon l'une quelconque des revendications précédentes, **caractérisé en ce qu'**il est apte pour être relié à un ou plusieurs dispositifs de réception d'énergie collectée, dans lequel le(s) dispositif(s) de réception d'énergie est/sont de préférence choisis d'un élément, ou une combinaison d'éléments, parmi le groupe constitué de :
- un élément d'éclairage constitué de LED ou OLED ;
- un élément de capteur pour détecter : la présence, le trafic, la pollution ou le Wi-Fi ;
- un élément de signalisation de trafic de type intermittent, ou SOS dans des zones de desserte ;
- une station de recharge pour des téléphones portables ou d'autres éléments portables tels que des tablettes ou des ordinateurs ;
- un élément électronique du type utilisé sur des voies publiques.

10. Mobilier urbain selon l'une quelconque des revendications précédentes, **caractérisé en ce qu'**il comprend une surface ou feuille intérieure thermiquement isolée aménagée sur la partie intérieure de toute la surface photovoltaïque (4), ou une partie de celle-ci.

11. Mobilier urbain selon l'une quelconque des revendications précédentes, **caractérisé en ce qu'**il comprend une pluralité d'ouvertures pour la ventilation aménagées de préférence dans la partie inférieure, aptes pour créer un courant d'air naturel qui pénètre dans lesdites ouvertures inférieures et sorte à travers d'autres ouvertures prévues dans la partie supérieure, en contact entre le module photovoltaïque (3) et la voûte (5).

12. Mobilier urbain selon la revendication 1, **caractérisé en ce que** la surface photovoltaïque (4) présente les paramètres suivants :
- diamètre inférieur (D2) = 800 mm,
- diamètre supérieur (D1) = 385 mm,
- hauteur (H) = 537 mm,
- hauteur (h) de changement de courbure = 268 mm,
- angle de courbure inférieur de la génératrice (Alpha 1) = 87,5°
- angle de change de courbure de la génératrice (Alpha 2) = 71,2 et angle de courbure supérieur de la génératrice (Alpha 3) = 41,5°
- distance de changement de courbure = 41,5 mm,
- distance de départ d'ouverture supérieure = 204,7 mm.

13. Mobilier urbain selon l'une quelconque des revendications précédentes, **caractérisé en ce que** ledit mobilier urbain est un luminaire (12).
